# EUROPÄISCHE PATENTANMELDUNG

(11) **EP 1 420 330 A2**
(43) Veröffentlichungstag der Anmeldung: **19.05.2004**
(21) Anmeldenummer: 03026133.3
(22) Anmeldetag: 13.11.2003
(51) Int. Cl.: G06F 1/18

(54) **Stromversorgung für ein elektrisches Gerät**

(30) Priorität: 13.11.2002 DE 10252829
(71) Anmelder: Fujitsu Siemens Computers GmbH, 80807 München (DE)
(72) Erfinder: Schmid, Michael, 89407 Dillingen (DE); Kannler, Bernhard, 86199 Augsburg (DE)
(74) Vertreter: Epping, Hermann, Fischer

(57) **Zusammenfassung**

Die Erfindung betrifft eine Stromversorgung (1) für ein elektrisches Gerät mit einer Buchse (2) für einen Netzstecker (3), wobei die Stromversorgung zu Service- oder Montagezwekken aus dem elektrischen Gerät ausgebaut werden kann. Um einen elektrischen Anschluß der Stromversorgung im ausgebauten Zustand zu verhindern, ist diese erfindungsgemäß mit einem Einsteckschutz versehen, welcher ein Einstecken des Netzstekkers (3) im ausgebauten Zustand verhindert.

## Beschreibung

Die Erfindung betrifft eine Stromversorgung für ein elektrisches Gerät mit einer Buchse zum Anschluß eines Netzsteckers, wobei die Stromversorgung zu Servicezwecken aus dem elektrischen Gerät entfernt werden kann.

Insbesondere bei Computern mit kleiner Baugröße ist es notwendig, die Stromversorgung zu entnehmen, um z.B. das Motherboard auswechseln zu können.

Für einige Servicearbeiten, wie z.B. der Wechsel von Laufwerken ist der Ausbau der Stromversorgung nicht zwingend erforderlich, jedoch vorteilhaft, da der Zugang zu den Laufwerken bei ausgebauter Stromversorgung oft wesentlich leichter ist.

Bei den meisten derzeit am Markt befindlichen Computern muß die Stromversorgung zum Wechseln des Motherboards nicht ausgebaut werden. Bei anderen Modellen ist sie schwenkbar mit den Chassis verbunden und kann zum Auswechseln des Motherboards für Servicearbeiten lediglich zur Seite geschwenkt werden.

Bei Geräten, bei denen jedoch die Stromversorgung ausgebaut werden kann, besteht die Gefahr, daß im ausgebauten Zustand die Stromversorgung an die Netzleitung angeschlossen wird.

Von einigen Servicetechnikern wird dies praktiziert um auch mit ausgebauter Stromversorgung z.B. die Funktionsfähigkeit des neu eingebauten Motherboards zu überprüfen. Eine Stromversorgung ist jedoch nicht für den Betrieb außerhalb des Computergehäuses ausgelegt, so daß sich ein erhebliches Gefahrenpotential beim Anschluß der Stromversorgung an das Netz im ausgebauten Zustand ergibt.

Der Erfindung liegt daher die Aufgabe zugrunde, eine Lösung aufzuzeigen, welche dieses Gefahrenpotential reduziert.

Die Aufgabe wird erfindungsgemäß dadurch gelöst, daß die Stromversorgung mit einem Einsteckschutz versehen ist, welcher das Einstecken des Netzsteckers verhindert, wenn die Stromversorgung nicht im bestimmungsgemäßen Ort des elektrischen Gerätes eingebaut ist.

Durch den Einsteckschutz wird vermieden, daß die ausgebaute Stromversorgung unbeabsichtigterweise an das Netz angeschlossen wird und somit eine Gefahrensituation entsteht, welche handelnde Person nicht unmittelbar erkannt hätte.

Die meisten Stromversorgungen, welche für Service- bzw. Wartungsarbeiten ausgebaut werden können, weisen einen Montagerahmen auf, in welchem der Einsteckschutz günstigerweise durch einen Schieber realisiert ist.

Der Schieber ist vorzugsweise dabei so ausgestaltet, daß er im ausgebauten Zustand der Stromversorgung die Buchse, in welche der Netzstecker eingesteckt werden kann, zumindest teilweise abdeckt.

Gemäß einer bevorzugten Ausführungsform ist der Schieber durch eine Feder beaufschlagt, welche den Schieber in eine Verriegelungsposition drückt, in welcher ein Netzstecker in die Buchse nicht mehr eingesteckt werden kann.

Die Feder ist hierbei günstigerweise so ausgebildet, daß man nur durch Druck auf zwei verschiedene Stellen der Feder den Schieber aus der Verriegelungsposition bewegen kann. Dies entspricht einer Zweihandsicherung, so daß nicht unbeabsichtigterweise der Schieber im ausgebauten Zustand der Stromversorgung gelöst wird.

Beim Einbau der Stromversorgung in das elektrische Gerät ist die Feder vorzugsweise so angeordnet, daß sie automatisch durch den Einbau der Stromversorgung in das elektrische Gerät gelöst wird und auch der Schieber automatisch von der Verriegelungsposition in eine Position geschoben wird, in welcher der Netzstecker in die Buchse eingesteckt werden kann.

Hierzu ist vorzugsweise am Gehäuse des elektrischen Gerätes eine Aufnahme vorgesehen, in welcher der Montagerahmen der Stromversorgung einschiebbar ist und welche zum einen die Feder entriegelt und gleichzeitig mit einer Kante den Schieber in die Entriegelungsposition schiebt.

Der Schieber sowie die Aufnahme für den Montagerahmen der Stromversorgung sind vorteilhafterweise so aufeinander abgestimmt, daß auch ein Bewegen des Montagerahmens aus der Aufnahme bei eingestecktem Netzstecker nicht möglich ist.

Weitere Vorteile der Erfindung sowie genauere Ausführungsformen sind in der nachfolgenden Figurenbeschreibung offenbart.

Anhand eines in den Zeichnungen dargestellten Ausführungsbeispieles wird die Erfindung näher erläutert.

In den Zeichnungen zeigen:
Figur 1 eine Explosionsdarstellung der Stromversorgung mit Montagerahmen,
Figur 2 eine Explosionsdarstellung des Montagerahmens sowie eine Darstellung des Montagerahmens im montierten Zustand,
Figur 3 eine Stromversorgung mit Montagerahmen in Entriegelungsposition,
Figur 4 eine Aufnahme für den Montagerahmen am Gehäuse eines elektronischen Gerätes,
Figur 5 die Stromversorgung mit Montagerahmen mit Schieber in Verriegelungsposition,
Figur 6 eine Schrägansicht einer Stromversorgung, wie sie in der Aufnahme eines elektronischen Gerätes montiert ist und
Figur 7 die Ansicht gemäß Figur 6 auf die Anschlußseite der Stromversorgung.

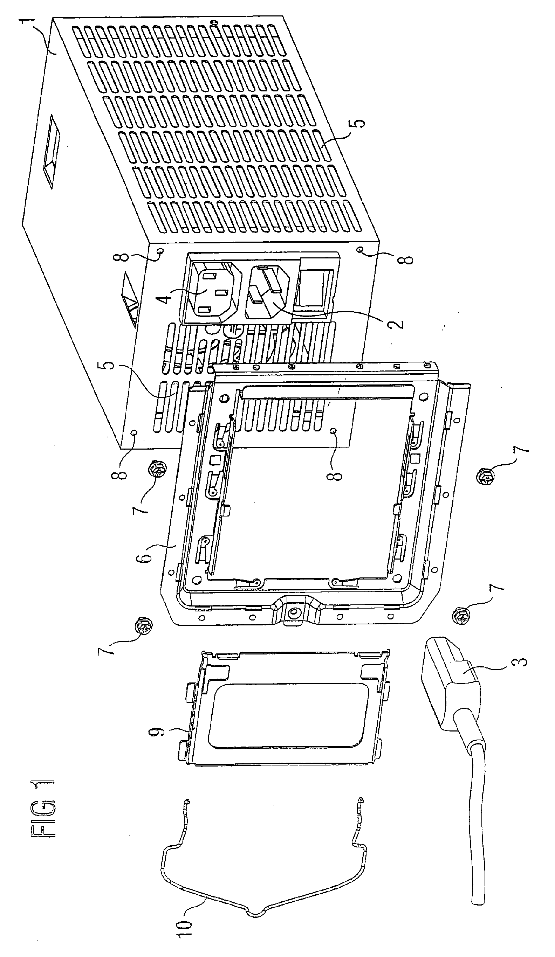

Figur 1 zeigt in Explosionsdarstellung eine Stromversorgung 1, wie sie bei einem Computer verwendet wird. Die Stromversorgung 1 weist an ihrer Stirnseite eine Buchse 2 auf, in welche ein entsprechender Netzstecker 3 zur Stromversorgung eingesteckt werden kann. Oberhalb der Buchse 2 ist in der Regel eine weitere Buchse 4 ausgebildet, welche in der Regel zum Anschluß der Stromversorgung für den Monitor dient.

Die Stromversorgung 1 ist an der Stirnseite neben den Buchsen 2 und 4 sowie an der Seitenfläche mit einem Lüftungsgitter 5 versehen.

Zur Montage der Stromversorgung 1 in einen Computer bzw. ein sonstiges elektrisches Gerät wird diese an der Seite, an welcher die Buchsen 2 und 4 angeordnet sind, mit einem Montagerahmen 6 versehen. Im dargestellten Ausführungsbeispiel wird der Montagerahmen 6 über Schrauben 7 in entsprechende Gewindebohrungen 8 an der Stromversorgung 1 festgelegt.

Um im ausgebauten Zustand der Stromversorgung 1 den Netzstekker 3 nicht in die Buchse 2 einstecken zu können, ist erfindungsgemäß im Montagerahmen 6 ein Schieber 9 aufgenommen, welcher über eine Feder 10 in eine Verriegelungsstellung gedrückt wird, damit im ausgebauten Zustand der Stromversorgung 1 der Netzstecker 3 nicht in die Buchse 2 eingeschoben werden kann.

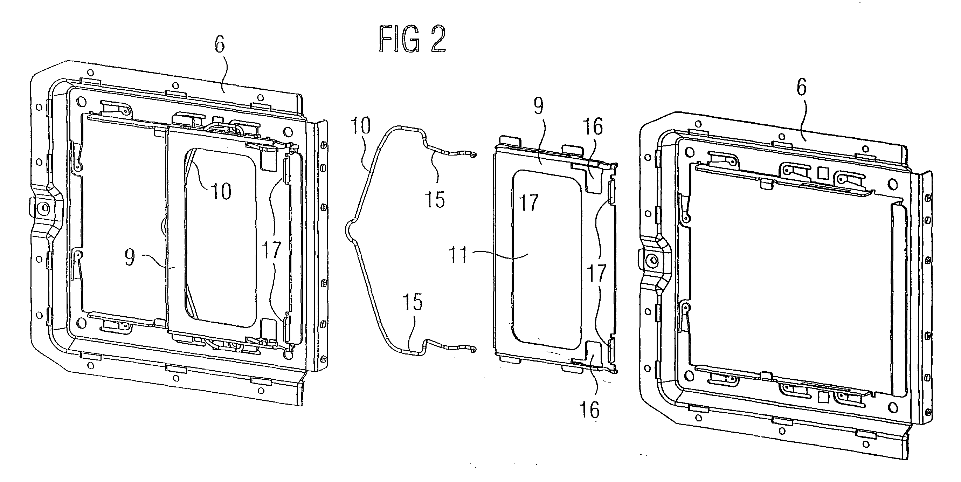

Figur 2 zeigt den Montagerahmen 6, den Schieber 9 sowie die Feder 10 im montierten Zustand sowie nochmals wie in Figur 1 bereits gezeigt eine Explosionsdarstellung.

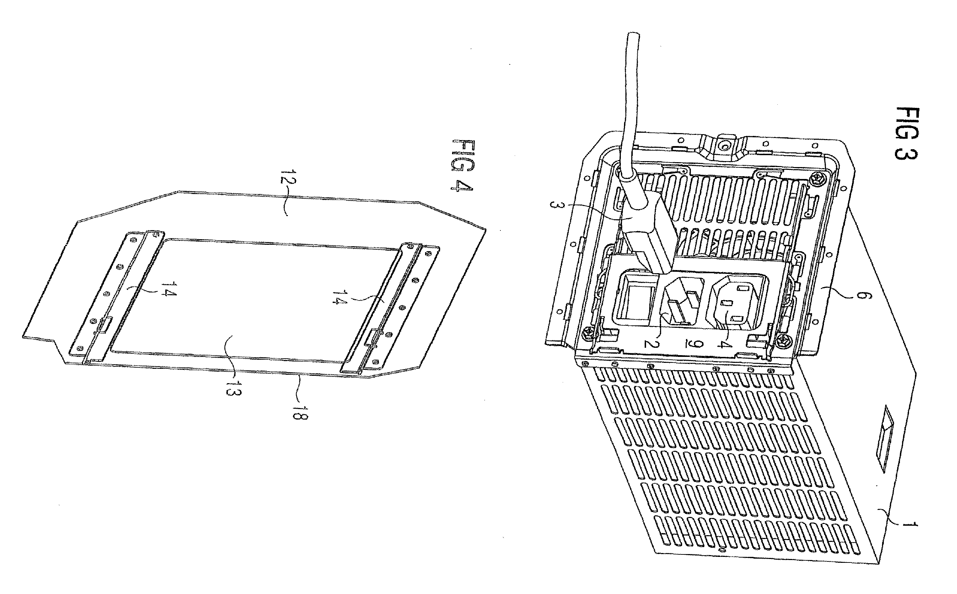

Figur 3 zeigt die Stromversorgung 1 mit montiertem Montagerahmen 6 und dem Schieber 9 in Entriegelungsposition, d.h. in der Position, in welcher der Netzstecker 3 in die Buchse 2 eingesteckt werden kann. Der Schieber 9 weist hierzu eine im wesentlichen rechteckige Aussparung 11 auf, welche die Buchse 2 sowie auch die Buchse 4 und einen darunterliegenden Bereichsumschalter für 110V / 220 V umschließt.

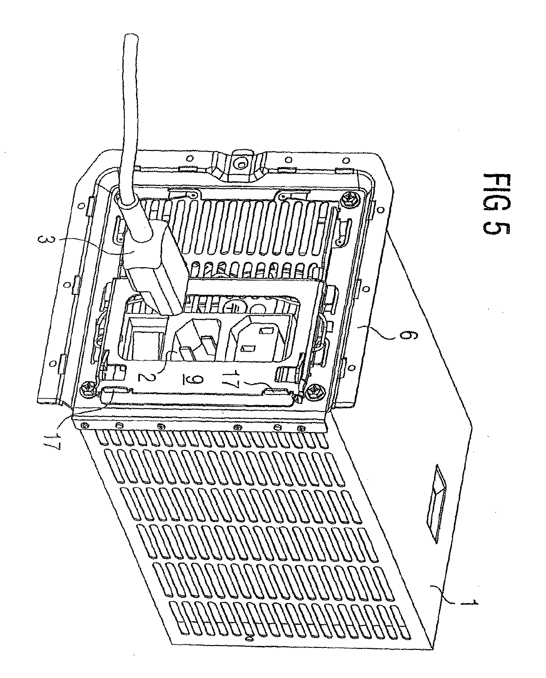

Figur 4 zeigt eine Aufnahme 12, wie sie an der Innenseite eines Computergehäuses bzw. eines elektrischen Gerätes zur Festlegung der Stromversorgung 1 über den Montagerahmen 6 vorgesehen ist.

Die Aufnahme 11 weist hierzu eine im wesentlichen rechteckige Aussparung 13 auf, welche an der Ober- und Unterseite über zwei abgesetzte Laschen 14 begrenzt ist, so daß der Montagerahmen 6 zwischen die Laschen 14 und die Aufnahme 12 eingeschoben werden kann.

Der Montagerahmen 6 ist hierzu im Vergleich zu den Außenabmessungen der Stromversorgung 1 so dimensioniert, daß er nach oben und unten übersteht, so daß er mit dem überstehenden Teil zwischen die Laschen 14 und die Aufnahme 12 eingeschoben werden kann.

Die Fläche der Aufnahme 12 wirkt beim Einschieben des Montagerahmens 6 mit Stromversorgung 1 zur Entriegelung des Schiebers 9.

Figur 5 zeigt die Darstellung gemäß Figur 3, wobei hier der Schieber 9 in Verriegelungsstellung dargestellt ist. Ein Einstecken des Netzsteckers 3 in die Buchse 2 wäre nicht möglich.

Wird wie in Figur 5 dargestellt, die Stromversorgung 1 mit dem Montagerahmen 6 in die Aufnahme 12 eingeschoben, so bewirkt die Fläche der Aufnahme 12, einen Druck auf die Feder 10 an den Punkten 15 (siehe Figur 2).

Wie in Figur 2 dargestellt, ist der Schieber 9 durch die Feder 10 aufgenommen, wobei sich die Enden der Feder 10 in entsprechenden Aussparungen 16 des Schiebers 9 verhaken. Durch Druck auf die Punkte 15 der Feder beim Einschieben des Montagerahmens 6 in die Aufnahme 12 werden somit die Enden aus den Aussparungen 16 bewegt, und der Schieber wird freigegeben.

Der Schieber 9 weist zwei nach außen abstehende Laschen 17 auf, welche beim Einschieben des Montagerahmens 6 gegen eine Kante 18 der Aufnahme 12 bewegt werden, welche somit bewirkt, daß der Schieber 9 an der in Figur 5 dargestellten Verriegelungsposition in die in Figur 3 dargestellte Entriegelungsposition bewegt wird. Gleichzeitig wird über die Aufnahme 12 wie oben beschrieben die Feder 10 entriegelt, so daß eine Bewegung des Schiebers 9 möglich ist.

Beim Entnehmen wird der Montagerahmen aus der Aufnahme 12 gezogen, wodurch ab einem gewissen Punkt die Entriegelungswirkung der Feder 10 aufgehoben wird und diese somit automatisch den Schieber 9 schließt.

Durch die Aussparung 13 in der Aufnahme 12 und das seitliche Einschieben des Montagerahmens 6 in die Aufnahme 12 ist es auch nicht möglich, bei eingestecktem Netzstecker 3 in die Buchse 2 die Stromversorgung 1 zu entnehmen.

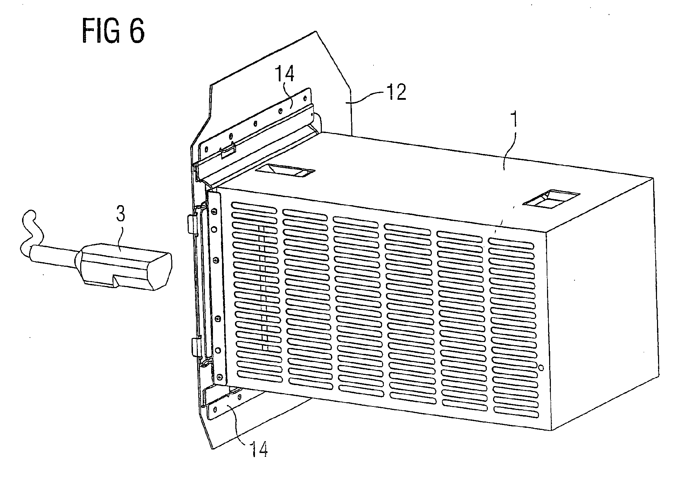

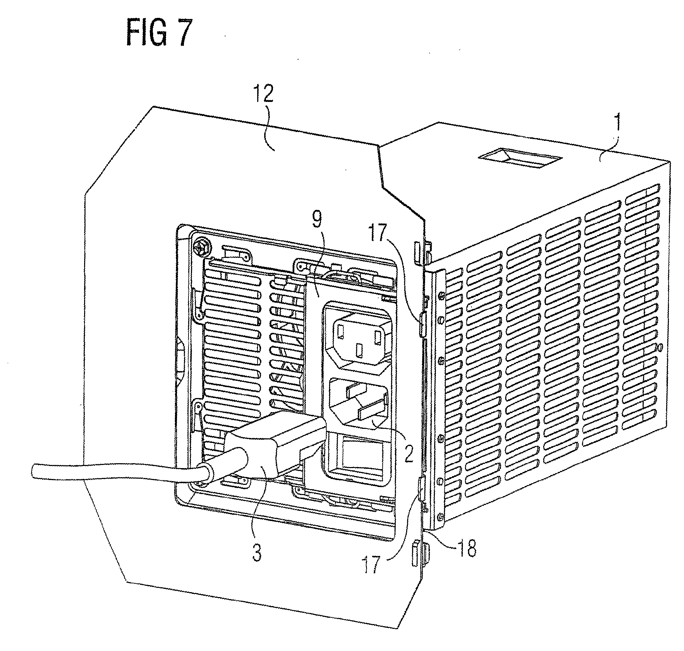

Die Figuren 6 und 7 zeigen in einer schrägen Ansicht von hinten sowie in einer schrägen Ansicht von vorne die komplett in der Aufnahme 12 montierte Stromversorgung 1. In Figur 7 ist zu erkennen, wie die seitliche Kante 18 in der Aufnahme 12 auf die Lasche 17 des Schiebers 9 einwirkt. Beim Entnehmen der Stromversorgung 1 wird diese auf die Seite der Kante 18 wieder herausgeschoben und der Schieber 9 durch die Feder 10 in Verriegelungsposition (siehe Figur 5) bewegt.

### Bezugszeichenliste

- 1.: Stromversorgung
- 2.: Buchse
- 3.: Netzstecker
- 4.: Buchse
- 5.: Lüftungsgitter
- 6.: Montagerahmen
- 7.: Schrauben
- 8.: Gewindebohrung
- 9.: Schieber
- 10.: Feder
- 11.: Aussparung
- 12.: Aufnahme
- 13.: Aussparung
- 14.: Laschen
- 15.: Punkte
- 16.: Aussparung
- 17.: Laschen
- 18.: Kante

## Patentansprüche

1. Stromversorgung (1) für ein elektrisches Gerät, mit einer Buchse (2) zum Anschluß eines Netzsteckers (3), wobei die Stromversorgung (1) zu Montage- oder Servicezwecken aus dem elektrischen Gerät entfernt werden kann,
**dadurch gekennzeichnet, daß**
die Stromversorgung (1) mit einem Einsteckschutz versehen ist, welcher das Einstecken des Netzsteckers (3) verhindert, wenn die Stromversorgung (1) nicht im bestimmungsgemäßen Ort des elektrischen Geräts eingebaut ist.

2. Stromversorgung nach Anspruch 1,
**dadurch gekennzeichnet, daß**
die Stromversorgung (1) einen Montagerahmen (6) aufweist und der Einsteckschutz durch einen Schieber (9) im Montagerahmen (6) realisiert ist.

3. Stromversorgung nach Anspruch 2,
**dadurch gekennzeichnet, daß**
der Schieber (9) die Buchse (2) im verriegelten Zustand zumindest teilweise abdeckt.

4. Stromversorgung nach Anspruch 3,
**dadurch gekennzeichnet, daß**
der Schieber (9) durch eine Feder (10) beaufschlagt in eine Verriegelungsposition geschoben wird, in der die Buchse (2) vom Schieber (9) zumindest teilweise abgedeckt ist.

5. Stromversorgung nach Anspruch 3 oder 4,
**dadurch gekennzeichnet, daß**
der Schieber (9) nur durch Krafteinwirkung auf die Feder (10) an zwei verschiedenen Positionen (15) (Zweihandsicherung) aus der Verriegelungsposition bewegbar ist.

6. Stromversorgung nach Anspruch 5,
**dadurch gekennzeichnet, daß**
die Stromversorgung (1) über den Montagerahmen (6) in einer Aufnahme (12) des elektrischen Gerätes einschiebbar ist und der Schieber durch das Einschieben automatisch aus der Verriegelungsposition gelöst wird.

7. Stromversorgung nach Anspruch 6,
**dadurch gekennzeichnet, daß**
die Aufnahme (12) eine Fläche aufweist, die auf die Feder (10) zur Entriegelung einwirkt und desweiteren eine Kante (18) aufweist, welche den Schieber (9) aus der Verriegelungsposition schiebt.

8. Stromversorgung nach einem der Ansprüche 1 bis 7,
**dadurch gekennzeichnet, daß**
der Einsteckschutz einen Ausbau der Stromversorgung (1) aus dem elektrischen Gerät bei eingestecktem Netzstecker (3) in die Buchse (2) verhindert.

9. Stromversorgung nach einem der Ansprüche 1 bis 8,
**dadurch gekennzeichnet, daß**
diese in einem Computer verwendet wird.
